# EUROPEAN PATENT SPECIFICATION

(11) **EP 3 451 401 B1**
(45) Date of publication and mention of the grant of the patent: **19.01.2022**
(21) Application number: 17764752.6
(22) Date of filing: 19.01.2017
(51) Int. Cl.: H01L 51/50, H01L 51/56, H01L 51/00

(54) **OLED DEVICE AND METHOD FOR MANUFACTURING SAME, AND OLED DISPLAY PANEL**
OLED-VORRICHTUNG UND VERFAHREN ZUR HERSTELLUNG DAVON UND OLED-ANZEIGEVORRICHTUNG
DISPOSITIF DELO ET SON PROCÉDÉ DE FABRICATION, ET ÉCRAN D'AFFICHAGE DELO

(30) Priority: 28.04.2016 CN 201610279225
(43) Date of publication of application: 06.03.2019
(73) Proprietor: BOE Technology Group Co., Ltd., Beijing 100015 (CN); Beijing BOE Optoelectronics Technology Co., Ltd., Beijing 100176 (CN)
(72) Inventor: DONG, Fei, Beijing 100176 (CN); GAI, Xin, Beijing 100176 (CN); CHEN, Xiuyun, Beijing 100176 (CN)
(74) Representative: Klunker IP Patentanwälte PartG mbB
(86) International application number: PCT/CN2017/071725
(87) International publication number: WO 2017/185839

(56) References cited:
- WO-A1-03/022007
- CN-A- 101 180 304
- CN-A- 102 945 928
- CN-A- 103 329 621
- CN-A- 105 895 819
- US-A1- 2006 115 673
- US-A1- 2007 075 631
- US-A1- 2009 026 929
- US-A1- 2012 211 735
- US-A1- 2013 292 664
- KIM SUNG ET AL: "High efficiency phosphorescent organic light-emitting diodes using carbazole-type triplet exciton blocking layer", APPLIED PHYSICS LETTERS, A I P PUBLISHING LLC, US, vol. 90, no. 22, 31 May 2007 (2007-05-31), pages 223505-1-223505-3, XP012095088, ISSN: 0003-6951, DOI: 10.1063/1.2742788

## Description

### TECHNICAL FIELD

The present invention relates to an organic light-emitting diode (OLED), a manufacturing method thereof and an OLED display panel.

### BACKGROUND

An OLED is an organic thin film electroluminescent device and has the advantages of simple manufacturing process, low cost, capability of easily forming a flexible structure, wide viewing angle, etc. Therefore, display technology utilizing OLEDs has become an important display technology.

US 2013/292664 A discloses an organic electroluminescence device including a pair of electrodes and an organic compound layer interposed therebetween. The organic compound layer includes a plurality of emitting layers including a first emitting layer and a second emitting layer, in which at least one of the first and second emitting layers contains a phosphorescent dopant material, and a space layer between the first and second emitting layers. The space layer contains a compound satisfying the formula DeltaST=EgS-Eg77K@0.5 (eV), wherein EgS is the singlet energy and Eg77K is the energy gap at 77K.

US 2007/075631 A1 discloses an OLED comprising an electron impeding layer between the cathode and the emissive layer. An organic light emitting device, comprising: an anode; a hole transport layer; an organic emissive layer comprising an emissive layer host and an emissive dopant; an electron impeding layer; an electron transport layer; and a cathode disposed, in that order, over a substrate.

Jwo-Huei Jou et al. "Sunlight-style color-temperature tunable organic light-emitting diode", Appl. Phys. Lett. 95, 013307 (2009), discloses the effect of the emitting layer arrangement on the color temperature and color temperature span of the sun light-style emission from OLEDs comprising several emitting layers.

US 2006/1 15673 A1 discloses an organic light-emitting device comprising an anode, a hole injection layer, a hole transport layer and an organic emitting layer. An electron source is disposed over the organic emitting layer. The electron source comprises a cathode made from a noble metal such as Ag; a buffer layer made from Al doped with alkali fluoride or alkaline earth fluoride such as CsF; and an electron transport layer made from Al. Additionally, a layer of CuPc is provided between the buffer layer and the electron transport layer.

Alternatively, the electron source comprises a cathode made from a noble metal and an electron transport layer made from Al:CsF/CuPc disposed between the cathode and the organic emitting layer.

### SUMMARY

It is an object of the present invention to provide an organic light-emitting diode (OLED), and a method for manufacturing the OLED.

The object is achieved by the features of the respective independent claims. Further embodiments are defined in the corresponding dependent claims.

### BRIEF DESCRIPTION OF THE DRAWINGS

In order to clearly illustrate the technical solution of the embodiments of the disclosure, the drawings of the embodiments will be briefly described in the following, it is obvious that the described drawings are only related to some embodiments of the disclosure and thus are not limitative of the disclosure.
FIG. 1 is a schematic structural view of a conventional OLED;
FIG. 2 is a schematic diagram illustrating a transformation of a chromaticity coordinate of a conventional OLED when the driving voltage is from 7 V to 21 V;
FIG. 3 is a schematic structural view of an OLED provided by an embodiment of the present disclosure;
FIG. 4 is a schematic structural view of an OLED provided by another embodiment of the present disclosure;
FIG. 5 is a schematic structural view of an OLED provided by another embodiment of the present disclosure;
FIG. 6 is a schematic diagram illustrating a transformation of a chromaticity coordinate of an OLED provided by an embodiment of the present disclosure when the driving voltage is from 7 V to 21 V;
FIG. 7 is a schematic structural view of an OLED provided by still another embodiment of the present disclosure; and
FIG. 8 is a flow diagram of a method for manufacturing an OLED provided by an embodiment of the present disclosure.

Reference numerals of the accompanying drawings: 100 - substrate; 1 - anode; 2 - cathode; 3 - first EML; 4 - second EML; 5 - HTL; 6 - ETL; 7 - EBL; 8 - HIL; 9- EIL; 10 - third EML; 11 - buffer layer.

### DETAILED DESCRIPTION

In order to make objects, technical details and advantages of the embodiments of the disclosure apparent, the technical solutions of the embodiment will be described in a clearly and fully understandable way in connection with the drawings related to the embodiments of the disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present application for disclosure, are not intended to indicate any sequence, amount or importance, but distinguish various components. Also, the terms such as "a," "an," etc., are not intended to limit the amount, but indicate the existence of at least one.

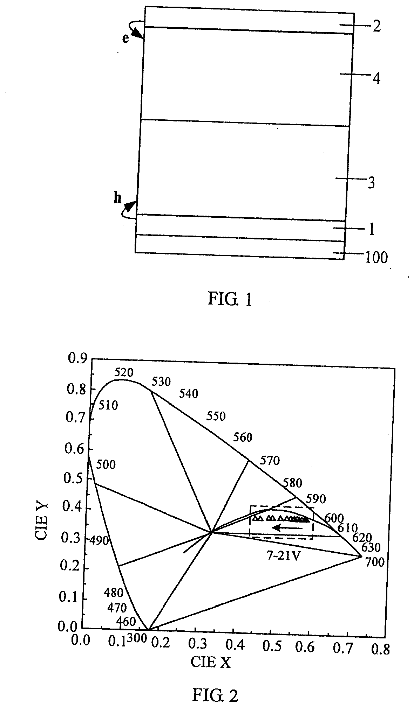

As shown in FIG. 1, a conventional white-light OLED comprises: a substrate 100, an anode 1 and a cathode 2 disposed on the substrate 100, and a first emitting layer (EML) 3 and a second emitting layer (EML) 4 disposed between the anode 1 and the cathode 2. The working principle of the conventional white-light OLED is that: holes injected from the anode 1 and electrons injected from the cathode 2 are recombined in the emitting layers (EMLs) to form excitons; the excitons excite luminescent molecules; and the excited luminescent molecules are subjected to radiative relaxation to emit visible light.

However, the researchers found that: the hole mobility is greater than the electron mobility (differ by three orders of magnitude). When a driving voltage applied to the OLED is increased, both the hole mobility and the electron mobility are increased, and the growth rate of the electron mobility is higher than the growth rate of the hole mobility, so the difference between the hole mobility and the electron mobility can be reduced. For instance, when an applied voltage is small, the electron mobility is low, so a number of electrons transferred into the second EML 4 close to the cathode 2 is greater than a number of electrons transferred into the first EML 3 close to the anode 1. Thus, the number of excitons in the second EML 4 is greater than the number of excitons in the first EML 3, so that the second EML 4 can receive more energy and have higher luminous intensity, and hence the luminous color of the OLED can be biased towards the color of the second EML 4. Along with the increase of the driving voltage, the growth rate of the electron mobility is higher than the growth rate of the hole mobility, so the difference between the hole mobility and the electron mobility can be further reduced. Moreover, due to the increase of the electron mobility, the number of electrons transferred into the first EML 3 is increased, so the number of excitons in the first EML 3 is also correspondingly increased. Thus, the first EML 3 receives more energy and has higher luminous intensity, so that the luminous intensity of the first EML 3 and the second EML 4 tend to be consistent.

Therefore, in a conventional white-light OLED, when a voltage applied to the OLED changes, the luminous color of the OLED is instable, and the chromaticity coordinate drift is severe. For instance, FIG. 2 shows an International Commission on Illumination (CIE) 1931 chromaticity coordinate system, when a driving voltage changes from 7V to 21V, a change of the chromaticity coordinate of the OLED is large, and the luminous color changes from red to pink and then to white, so the color stability is poor.

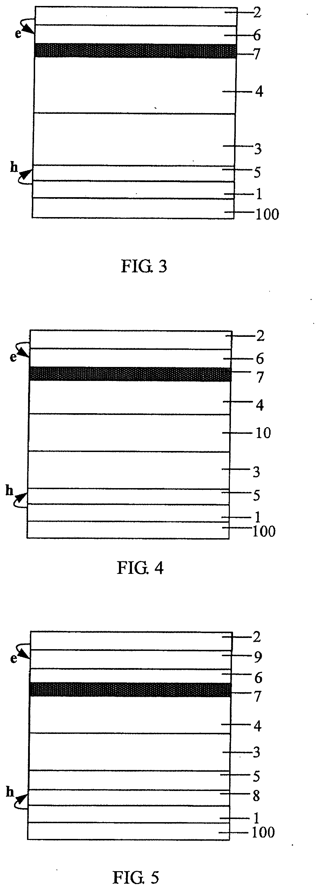

The embodiment of the present disclosure provides an OLED. As illustrated in FIGS. 3-5, the OLED comprises a substrate 100, an anode 1 and a cathode 2 disposed on the substrate 100, a HTL 5 and an ETL 6 disposed between the anode 1 and the cathode 2, and at least two EMLs (3, 4, 10) disposed between the HTL 5 and the ETL 6, wherein the at least two EMLs (3, 4, 10) emit white light. Moreover, the OLED further comprises an EBL 7 disposed between the ETL 6 and the at least two EMLs (3, 4, 10); a material of the EBL (7) is a hole transport material; the at least two EMLs (3, 4, 10) comprise a red emitting layer, red EML (4) and a blue emitting layer, blue EML (3); and the red EML (4) is arranged closer to the EBL (7) as compared to the blue EML (3); and the blue EML (3) is arranged closer to the HTL (5) as compared to the red EML.

The embodiment of the present disclosure obtains stable luminous color by the arrangement of the EBL 7. When a low voltage is applied, the increase of the electron mobility in the embodiment of the present disclosure is inhibited, so the number of electrons transferred to the EMLs tends to be identical, and hence the number of excitons in the EMLs tends to be identical. Thus, the luminous intensity of the EMLs also tends to be identical, so the OLED emits white light. Along with the increase of the applied voltage, although the growth rate of the electron mobility is higher than the growth rate of the hole mobility, due to the blocking function of the EBL 7 on electron transfer, the number of the electrons transferred to the EMLs still tends to be identical. Thus, the luminous intensity of the EMLs tends to be identical, so the OLED still emits white light.

The HTL 5 is made from hole transport materials. The hole transport materials may be triarylamine compounds, biphenyl diamine derivatives or cross-linked diamine biphenyl, for instance, may be N,N'-Diphenyl-N,N'-bis(a-naphthyl)-1,1'-biphenyl-4,4'-diamine (NPB), 4,4',4"-Tris(9-carbazoyl)triphenylamine (TCTA), 4,4',4"-Tris(N-3-methylphenyl-N-phenylamino) triphenylamine (m-MTDATA), etc.

The ETL 6 is made from electron transport materials. The electron transport materials may be metal chelates, azole compounds, phenanthroline derivatives or the like, for instance, may be: tris(8-hydroxyquinoline)aluminum (AlQ₃), 4,7-diphenyl-1,10-orthophenanthroline (BPhen), 1,3,5-tris[(3-pyridyl)-3-phenyl]benzene (TmPyPB), 2,2'-(1,3-phenyl)bis[5-(4-tert-butylphenyl)-1,3,4-oxadiazole] (OXD-7), etc.

It should be noted that: firstly, the specific number of the at least two EMLs is not limited, as long as white light can be emitted. The structure as shown in FIGS. 3 and 5 includes two EMLs, namely the first EML 3 and the second EML 4; and the structure as shown in FIG. 4 includes three EMLs, namely the first EML 3, the second EML 4 and a third EML 10.

A material of each EML in the at least two EMLs may be a hole transport material or an electron transport material.

For instance, the EML close to the anode 1 is made from the hole transport materials, and the EML close to the cathode 2 is made from the electron transport materials. As shown in FIG. 3, for instance, a material of the first EML 3 is a hole transport material, and a material of the second EML 4 is an electron transport material.

Secondly, a material of the EBL 7 is not specifically limited, as long as the EBL can have the function of blocking electrons. According to the invention, of the EBL is a hole transport material.

Thirdly, as shown in FIG. 5, in order to increase the injection efficiency of the electrons and the holes, an HIL 8 may be further disposed between the anode 1 and the first EML 3, and an EIL 9 may be further disposed between the cathode 2 and the second EML 4.

The embodiment of the present disclosure provides an OLED. As the EBL 7 is disposed between the at least two EMLs and the ETL 6, a change of the electron mobility may be inhibited when the driving voltage applied to the OLED changes, so that the number of electrons transferred to the EMLs tends to be identical, and hence the number of excitons in the EMLs tends to be identical. Thus, the luminous intensity of the EMLs tends to be identical, so that the luminous color of the OLED can be stable and the chromaticity coordinate drift can be reduced.

Considering that 9,9-(1,3-Phenylene)bis-9H-carbazole (mCP) materials are good hole transport materials, electron transfer blocking effects can be well achieved using mCP. Therefore, a material of the EBL 7, for instance, may comprise mCP.

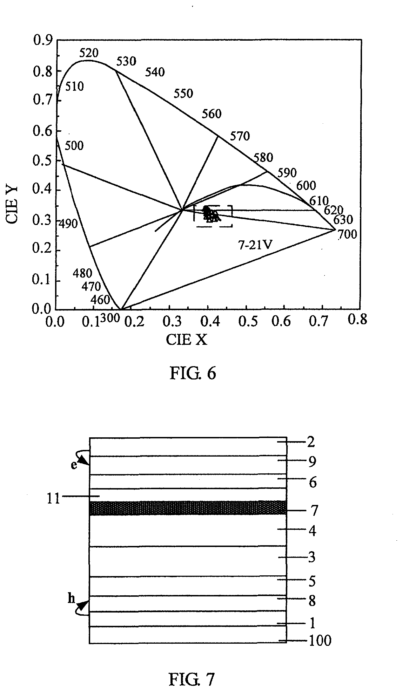

As shown in FIG. 6 which is a CIE1931 chromaticity coordinate system, in the case that a material of the EBL 7 comprises mCP, when the driving voltage gradually changes from 7 V to 21 V, as shown by dotted lines in FIG. 6 (triangles in the dotted lines refer to the chromaticity coordinates of the luminous color of the OLED under different driving voltages), a change of the chromaticity coordinate of the OLED is small, and good color stability is obtained.

For instance, a thickness of the EBL 7 is from 5 nm to 15 nm.

When the thickness of the EBL 7 is set from 5 nm to 15 nm, electron transfer can be well blocked by the EBL. For example, when the thickness of the EBL 7 is 10 nm, the electron blocking effect is good, and the entire OLED is light and thin.

According to the invention, the at least two EMLs comprise a red EML and a blue EML; the red EML is arranged closer to the EBL 7 as compared to the blue EML; and the blue EML is arranged closer to the HTL 5 as compared to the red EML.

That is to say, as shown in FIG. 3, the first EML 3 is a blue EML, and the second EML 4 is a red EML.

A material of the blue EML, for instance, may adopt a host-guest doping system, in which host materials may adopt iridium (Ir) complexes such as bis(4,6 difluorophenylpyridinato-N,C2)picolinatoiridium (FIrpic), and guest materials may adopt 4,4'-Bis(N-carbazolyl)-1,1-biphenyl (CBP), 1,3-bis(triphenylsilyl)benzene (UGH3), mCP, etc. For instance, the materials of the blue EML are CBP: 9% FIrpic.

A material of the red EML, for instance, may adopt a host-guest doping system, in which a guest material may adopt Ir complexes such as bis(2-methyldibenzo[F,H]quinoxaline)(acetylacetonate)iridium(III) (Ir(MDQ)2acac), and a host material may adopt CBP, etc. For instance, the materials of the red EML are CBP: 2% Ir(MDQ)2acac.

In the present embodiment of the disclosure, as red and blue are two complementary colors, the superimposition of the blue EML and the red EML allows the OLED to emit white light. As the blue EML comprises hole transport materials, an energy level difference between the EML and the anode 1 can be reduced by disposing the blue EML close to the HTL 5 and hence the luminescent properties of the EML can be improved; and as the red EML comprises electron transport materials, the energy level difference between the EML and the cathode 2 can be reduced by disposing the red EML close to the ETL 6 and hence the luminescent properties of the EML can be improved.

For instance, a material of the EBL 7 comprises mCP; and a host material of the blue EML comprises mCP.

In the present embodiment of the disclosure, a host material of the EBL 7 and the blue EML adopt same materials, as a result, a replacement frequency of different materials in the evaporation process is reduced, and hence the manufacturing process is simplified and the production efficiency is improved.

For instance, the at least two EMLs comprise a red EML, a blue EML and a green EML; and the green EML is disposed between the red EML and the blue EML.

That is to say, as shown in FIG. 4, the first EML 3 is a blue EML; the second EML 4 is a red EML; and the third EML 10 is a green EML.

Compared with the OLED only comprising a red EML and a blue EML, the OLED further comprising a green EML has higher color rendering index.

On this basis, considering that the energy level difference between the cathode 2 and the ETL 6 is large and the electron transport efficiency is low, for instance, as shown in FIG. 7, the OLED further comprises a buffer layer 11 disposed on a surface of the cathode 2 facing the ETL 6. The buffer layer 11 is configured to match the energy level of the cathode 2 and the ETL 6.

The materials of the buffer layer 11 are not specifically limited, as long as the buffer layer can achieve the energy level buffering between the cathode 2 and the ETL 6. For instance, a material of the buffer layer 11 may be LiF, etc.

An embodiment of the present disclosure provides an OLED display panel, which comprises the foregoing OLED.

In the OLED display panel provided by the embodiment of the present disclosure, as the EBL 7 is disposed between the at least two EMLs and the ETL 6 of the OLED, when a driving voltage applied to the OLED changes, the change of the electron mobility can be inhibited, so the number of electrons transferred to the EMLs tends to be identical, and hence the number of excitons in the EMLs tends to be identical. Thus, the luminous intensity of the EMLs tends to be identical, so that the luminous color of the OLED is stabilized and the chromaticity coordinate drift is reduced, and hence the display effect of the OLED display panel can be improved.

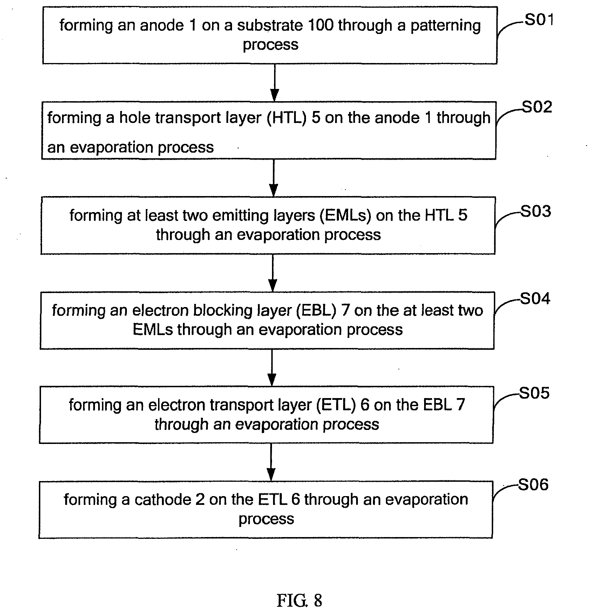

The embodiment of the present disclosure provides a method for manufacturing an OLED. As illustrated in FIG. 8, the method comprises:
S01: as shown in FIGS.3-4, forming an anode 1 on a substrate 100 through a patterning process.

The substrate 100, for instance, may be transparent glass. A material of the anode 1, for instance, may be indium tin oxide (ITO).

Considering that a surface state of the anode 1 directly affects hole injection, affects the interface electronic state of organic layers, and affects the film forming property of organic materials, the surface treatment of the substrate 100 is very important. On this basis, before the anode 1 is formed, the substrate 100 must be subjected to surface treatment, for instance, including: placing the cleaned substrate 100 into clean water, anhydrous ethanol, acetone, anhydrous ethanol, acetone and isopropyl alcohol respectively, adopting an ultrasonic wave cleaner for treatment, and placing the substrate into anhydrous ethanol for storage after the completion of cleaning.

S02: as shown in FIGS. 3-4, forming a HTL 5 on the anode 1 through an evaporation process.

A hole transport material may comprise triarylamine compounds, biphenyl diamine derivatives or cross-linked diamine biphenyl, for instance, may be NPB, TCTA, m-MTDATA, etc.

S03: forming at least two EMLs on the HTL 5 through an evaporation process.

As shown in FIG. 3, the at least two EMLs comprise a first EML 3 and a second EML 4. Or as shown in FIG. 4, the at least two EMLs comprise a first EML3, a second EML 4 and a third EML 10.

The first EML 3 is a blue EML; the second EML 4 is a red EML; and the third EML 10 may be a green EML.

S04: forming an EBL 7 on the at least two EMLs through an evaporation process.

A material of the EBL 7 is not specifically limited, as long as an electron blocking effect can be obtained through the EBL. According to the invention, material of the EBL comprises a hole transport material.

S05: forming an ETL 6 on the EBL 7 through an evaporation process.

The ETL 6 is made from electron transport materials. The electron transport materials may comprise metal chelates, azole compounds, phenanthroline derivatives or the like, for instance, may be: AlQ₃, BPhen, TmPyPB, OXD-7.

S06: forming a cathode 2 on the ETL 6 through an evaporation process.

A material of the cathode 2 may comprise metallic materials such as aluminum (Al), aurum (Au), argentums (Ag) and magnesium (Mg)-Ag alloy.

In an example of the present disclosure, but not forming part of the claimed invention, the evaporation process, for instance, may include: evaporating target materials into atoms or molecules by electric heating. The atoms and the molecules will be disengaged from the materials and move up due to thermal motion, make contact with the substrate 100 in the moving process, and are accumulated and condensed on the substrate 100 to form layers. The processes of forming the layers by high-temperature evaporation are all performed in an environment with a pressure less than 4×10⁻⁴ Pa.

The embodiment of the present disclosure provides a method for manufacturing an OLED. As the EBL 7 is formed between the at least two EMLs and the ETL 6, the change of the electron mobility may be inhibited when the driving voltage applied to the OLED changes, so that the number of electrons transferred to the EMLs tends to be identical, and hence the number of excitons in the EMLs tends to be identical. Thus, the luminous intensity of the EMLs tends to be identical, so that the luminous color of the OLED can be stabilized and the chromaticity coordinate drift is reduced.

According to the invention the forming the at least two EMLs comprises: forming a red EML and a blue EML, in which the red EML is formed closer to the EBL 7 as compared to the blue EML; the blue EML is formed closer to the HTL 5 as compared to the red EML; and a host material of the blue EML may comprise mCP. On this basis, the forming the EBL 7 includes: forming the EBL 7 with mCP.

In the present embodiment of the present disclosure, a host material of the EBL 7 and the blue EML adopt same materials, as a result, a replacement frequency of different materials in the evaporation process is reduced, and hence the manufacturing process is simplified and the production efficiency is improved.

For instance, the method further comprises forming a green EML. The green EML is disposed between the red EML and the blue EML.

For instance, a thickness of the EBL 7 is from 5 nm to 15 nm.

When the thickness of the EBL 7 is from 5 nm to 15 nm, electron transfer can be well blocked by the EBL. Particularly when the thickness of the EBL 7 is 10 nm, the electron blocking effect is good, and the entire OLED is light and thin.

## Claims

1. An organic light-emitting diode, OLED, comprising a substrate (100), an anode (1) and a cathode (2) disposed on the substrate (100), a hole transport layer, HTL, (5) and an electron transport layer, ETL, (6) disposed between the anode (1) and the cathode (2), and at least two emitting layers, EMLs, (3, 4, 10) disposed between the HTL (5) and the ETL (6), wherein the at least two EMLs (3, 4, 10) emit white light;
**characterized in that**
the OLED further comprises an electron blocking layer, EBL, (7) disposed between the ETL (6) and the at least two EMLs (3, 4, 10);
a material of the EBL (7) is a hole transport material;
the at least two EMLs (3, 4, 10) comprise a red emitting layer, red EML (4) and a blue emitting layer, blue EML (3); and
the red EML (4) is arranged closer to the EBL (7) as compared to the blue EML (3); and the blue EML (3) is arranged closer to the HTL (5) as compared to the red EML

2. The OLED according to claim 1, wherein a material of the EBL (7) comprises 9,9-(1,3-Phenylene)bis-9H-carbazole (mCP).

3. The OLED according to claim 1 or 2, wherein a thickness of the EBL (7) is from 5 nm to 15 nm.

4. The OLED according to any one of claims 1 to 3, wherein
a material of the EBL (7) comprises mCP; and
a host material of the blue EML (3) comprises mCP.

5. The OLED according to any one of claims 1 to 3, wherein
the at least two EMLs (3, 4, 10) further comprise a green EML (10); and
the green EML (10) is disposed between the red EML (4) and the blue EML (3).

6. The OLED according to claim 1, further comprising
a buffer layer (11) disposed on a surface of the cathode (2) facing the ETL (6); and
an energy level of the buffer layer (11) between an energy level of the cathode (2) and an energy level of the ETL (6).

7. An OLED display panel, comprising the OLED according to any one of claims 1 to 6.

8. A method for manufacturing an organic light-emitting diode, OLED, comprising:
forming an anode (1) through a patterning process; and
forming a hole transport layer, HTL, (5), at least two emitting layers, EMLs, (3, 4, 10), an electron transport layer, ETL, (6) and a cathode (2) on the anode (1) sequentially through an evaporation process, wherein the at least two EMLs (3, 4, 10) emit white light; and
**characterized in that**
the method further comprises forming an electron blocking layer, EBL, (7) between the at least two EMLs (3, 4, 10);
the ETL (6), and a material of the EBL (7) is a hole transport material;
forming of the at least two emitting layers, EMLs (3, 4, 10) comprises: forming a red emitting layer, red EML, (4) and a blue emitting layer, blue EML, (3), in which the red EML (10) is closer to the EBL (7) as compared to the blue EML (3), the blue EML (3) is closer to the HTL (5) as compared to the red EML (4), and a host material of the blue EML (3) comprises mCP; and
forming of the EBL (7) comprises: forming the EBL (7) with mCP.

9. The manufacturing method according to claim 8, wherein a thickness of the EBL (7) is from 5 nm to 15 nm.

## Patentansprüche

1. Organische lichtemittierende Diode, OLED, mit einem Substrat (100), einer Anode (1) und einer Kathode (2), die auf dem Substrat (100) angeordnet sind, einer Löchertransportschicht, HTL, (5) und einer Elektronentransportschicht, ETL, (6), die zwischen der Anode (1) und der Kathode (2) angeordnet sind, und mindestens zwei Emissionsschichten, EMLs, (3, 4, 10), die zwischen der HTL (5) und der ETL (6) angeordnet sind, wobei die mindestens zwei EMLs (3, 4, 10) weißes Licht emittieren;
**dadurch gekennzeichnet, dass**
die OLED ferner eine Elektronensperrschicht, EBL, (7) aufweist, die zwischen der ETL (6) und den mindestens zwei EMLs (3, 4, 10) angeordnet ist;
ein Material der EBL (7) ein Löchertransportmaterial ist;
die mindestens zwei EMLs (3, 4, 10) eine Rot-Emissionsschicht, Rot-EML (4), und eine Blau-Emissionsschicht, Blau-EML (3), aufweisen; und
die Rot-EML (4) im Vergleich zur Blau-EML (3) näher an der EBL (7) angeordnet ist; und die Blau-EML (3) im Vergleich zur Rot-EML näher an der HTL (5) angeordnet ist.

2. OLED nach Anspruch 1, wobei ein Material der EBL (7) 9,9-(1,3-Phenylen)bis-9H-carbazol (mCP) aufweist.

3. OLED nach Anspruch 1 oder 2, wobei die Dicke der EBL (7) zwischen 5 nm und 15 nm liegt.

4. OLED nach einem der Ansprüche 1 bis 3, wobei
ein Material der EBL (7) mCP aufweist; und
ein Wirtsmaterial der Blau-EML (3) mCP aufweist.

5. OLED nach einem der Ansprüche 1 bis 3, wobei
die mindestens zwei EMLs (3, 4, 10) ferner eine Grün-EML (10) aufweisen; und
die Grün-EML (10) zwischen der Rot-EML (4) und der Blau-EML (3) angeordnet ist.

6. OLED nach Anspruch 1, femer aufweisend
eine Pufferschicht (11), die auf einer der ETL (6) zugewandten Oberfläche der Kathode (2) angeordnet ist; und
ein Energieniveau der Pufferschicht (11) zwischen einem Energieniveau der Kathode (2) und einem Energieniveau der ETL (6).

7. OLED-Anzeigefeld, das die OLED nach einem der Ansprüche 1 bis 6 aufweist.

8. Verfahren zur Herstellung einer organischen lichtemittierenden Diode, OLED, aufweisend:
Ausbilden einer Anode (1) durch einen Strukturierungsprozess; und
Ausbilden einer Löchertransportschicht, HTL, (5), mindestens zweier Emissionsschichten, EML, (3, 4, 10), einer Elektronentransportschicht, ETL, (6) und einer Kathode (2) auf der Anode (1) nacheinander durch einen Aufdampfprozess, wobei die mindestens zwei EML (3, 4, 10) weißes Licht emittieren; und
**dadurch gekennzeichnet, dass**
das Verfahren ferner das Bilden einer Elektronensperrschicht, EBL, (7) zwischen den mindestens zwei EMLs (3, 4, 10) aufweist;
die ETL (6), und ein Material der EBL (7) ein Löchertransportmaterial ist;
Ausbilden der mindestens zwei Emissionsschichten, EMLs (3, 4, 10), aufweist:
Ausbilden einer Rot-Emissionsschicht, Rot-EML, (4) und einer Blau-Emissionsschicht, Blau-EML, (3), wobei die Rot-EML (10) näher an der EBL (7) liegt als die Blau-EML (3), die Blau-EML (3) näher an der HTL (5) liegt als die Rot-EML (4), und ein Wirtsmaterial der Blau-EML (3) mCP aufweist; und
Bilden der EBL (7), aufweisend: Bilden der EBL (7) mit mCP.

9. Herstellungsverfahren nach Anspruch 8, wobei die Dicke der EBL (7) zwischen 5 nm und 15 nm liegt.

## Revendications

1. Diode électroluminescente organique, OLED, comprenant un substrat (100), une anode (1) et une cathode (2) qui sont disposées sur le substrat (100), une couche de transport de trous, HTL, (5) et une couche de transport d'électrons, ETL, (6) qui sont disposées entre l'anode (1) et la cathode (2), et au moins deux couches d'émission, EML, (3, 4, 10) qui sont disposées entre la HTL (5) et l'ETL (6), dans laquelle les au moins deux EML (3, 4, 10) émettent de la lumière blanche ;
**caractérisée en ce que** :
l'OLED comprend en outre une couche de blocage d'électrons, EBL, (7) qui est disposée entre l'ETL (6) et les au moins deux EML (3, 4, 10) ;
un matériau de l'EBL (7) est un matériau de transport de trous ;
les au moins deux EML (3, 4, 10) comprennent une couche d'émission de rouge, EML rouge (4) et une couche d'émission de bleu, EML bleue (3) ; et
l'EML rouge (4) est agencée plus près de l'EBL (7) par comparaison avec l'EML bleue (3) ; et l'EML bleue (3) est agencée plus près de la HTL (5) par comparaison avec l'EML rouge.

2. OLED selon la revendication 1, dans laquelle un matériau de l'EBL (7) comprend du 9,9-(1,3-phénylène)bis-9H-carbazole (mCP).

3. OLED selon la revendication 1 ou 2, dans laquelle une épaisseur de l'EBL (7) va de 5 nm à 15 nm.

4. OLED selon l'une quelconque des revendications 1 à 3, dans laquelle :
un matériau de l'EBL (7) comprend du mCP ; et
un matériau hôte de l'EML bleue (3) comprend du mCP.

5. OLED selon l'une quelconque des revendications 1 à 3, dans laquelle :
les au moins deux EML (3, 4, 10) comprennent en outre une EML verte (10);et
l'EML verte (10) est disposée entre l'EML rouge (4) et l'EML bleue (3).

6. OLED selon la revendication 1, comprenant en outre :
une couche tampon (11) qui est disposée sur une surface de la cathode (2) qui fait face à l'ETL (6) ; et
un niveau d'énergie de la couche tampon (11) est situé entre un niveau d'énergie de la cathode (2) et un niveau d'énergie de l'ETL (6).

7. Panneau d'affichage à OLED, comprenant l'OLED selon l'une quelconque des revendications 1 à 6.

8. Procédé de fabrication d'une diode électroluminescente organique, OLED, comprenant :
la formation d'une anode (1) par l'intermédiaire d'un processus de formation de motif(s) ; et
la formation d'une couche de transport de trous, HTL, (5), d'au moins deux couches d'émission, EML, (3, 4, 10), d'une couche de transport d'électrons, ETL, (6) et d'une cathode (2) sur l'anode (1) de façon séquentielle par l'intermédiaire d'un processus d'évaporation, dans lequel les au moins deux EML (3, 4, 10) émettent de la lumière blanche ; et
**caractérisé en ce que** :
le procédé comprend en outre la formation d'une couche de blocage d'électrons, EBL, (7) entre les au moins deux EML (3, 4, 10) ;
l'ETL (6) et un matériau de l'EBL (7) sont un matériau de transport de trous ;
la formation des au moins deux couches d'émission, EML (3, 4, 10) comprend : la formation d'une couche d'émission de rouge, EML rouge (4) et d'une couche d'émission de bleu, EML bleue (3), dans lequel l'EML rouge (4) est plus près de l'EBL (7) par comparaison avec l'EML bleue (3), l'EML bleue (3) est plus près de la HTL (5) par comparaison avec l'EML rouge (4), et un matériau hôte de l'EML bleue (3) comprend du mCP ; et
la formation de l'EBL (7) comprend : la formation de l'EBL (7) avec du mCP.

9. Procédé de fabrication selon la revendication 8, dans lequel une épaisseur de l'EBL (7) va de 5 nm à 15 nm.
